# EUROPEAN PATENT SPECIFICATION

(11) **EP 3 195 432 B1**
(45) Date of publication and mention of the grant of the patent: **20.10.2021**
(21) Application number: 15841790.7
(22) Date of filing: 15.09.2015
(51) Int. Cl.: H01S 5/00, H04B 10/40, H01S 5/026, H01S 5/042, H01S 5/12

(54) **METHOD OF OPERATING AN OPTICAL MODULATOR**
VERFAHREN ZUR STEUERUNG EINES OPTISCHEN MODULATORS
PROCÉDÉ DE FONCTIONNEMENT D'UN MODULATEUR OPTIQUE

(30) Priority: 15.09.2014 US 201462050347 P; 11.02.2015 US 201514620010
(43) Date of publication of application: 26.07.2017
(73) Proprietor: Emcore Corporation, Alhambra, CA 91803 (US)
(72) Inventor: BLAUVELT, Henry, A., Alhambra, CA 91803 (US); HE, Xiaoguang, Alhambra, CA 91803 (US); VAHALA, Kerry, Alhambra, CA 91803 (US)
(74) Representative: Klang, Alexander H.
(86) International application number: PCT/US2015/050161
(87) International publication number: WO 2016/044258

(56) References cited:
- EP-A2- 2 778 770
- JP-A- 2012 094 622
- US-A- 5 680 411
- US-A1- 2005 018 732
- US-A1- 2005 018 732
- US-A1- 2011 134 957
- US-A1- 2011 150 484
- US-A1- 2012 099 185
- US-A1- 2012 163 405
- None

## Description

### FIELD OF THE INVENTION

This invention relates to a method of operating an optical transmission system for analog or digital radio frequency (RF) signals using an externally modulated solid-state laser, wherein said system comprises the external modulator and the laser.

### BACKGROUND

An optical telecommunication system transmits information from one place to another by way of an optical carrier whose frequency typically is in the visible or near-infrared region of the electromagnetic spectrum. A carrier with such a high frequency is sometimes referred to as an optical signal, an optical carrier, light beam, or a lightwave signal. The optical telecommunication system includes several optical fibers and each optical fiber includes multiple channels. A channel is a specified frequency band of an electromagnetic signal, and is sometimes referred to as a wavelength. The purpose for using multiple channels in the same optical fiber (called dense wavelength division multiplexing (DWDM)) is to take advantage of the high capacity (i.e., bandwidth) offered by optical fibers. Essentially, each channel has its own wavelength, and all wavelengths are separated enough to prevent overlap. International Telecommunications Union (ITU) standards currently determines the channel separations.

One link of an optical telecommunication system typically has a transmitter, the optical fiber, and a receiver. The optical transmitter has a laser, which converts an electrical signal into the optical signal and launches it into the optical fiber. The optical fiber transports the optical signal to the receiver. The receiver converts the optical signal back into an electrical signal.

Optical transmitters for the transmission of analog or digital radio-frequency (RF) signals over an optical fiber may use either a directly modulated laser or a continuous wave (CW) laser coupled to an external modulator.

Directly modulating the analog intensity of a light-emitting diode (LED) or semiconductor laser with an electrical signal is considered among the simplest methods known in the art for transmitting analog signals, such as voice and video signals, over optical fibers. Although such analog transmission techniques have the advantage of substantially smaller bandwidth requirements than digital transmission, such as digital pulse code modulation, or analog or pulse frequency modulation, the use of amplitude modulation typically places more stringent requirements on the noise and distortion characteristics of the transmitter. A limiting factor in such links can be the second order distortion due to the combination of optical frequency modulation, or chirp, and fiber dispersion.

For these reasons, direct modulation techniques have typically been used in connection with 1310 nm lasers where the application is to short transmission links that employ fiber optic links with low dispersion. It is also possible to use direct modulation of 1550 nm lasers, but in this case the distortion produced by chirp and dispersion must be cancelled using a predistorter that is set for the specific fiber length. In some case, such as when the signal must be sent to more than one location or through redundant fiber links of different length, such a programmable predistorter can be undesirable.

Stimulated Brillouin scattering (SBS) effects that depend on the optical launch power and the total fiber length may also degrade DWDM system performance. SBS is an opto-acoustic nonlinear process that can occur in single mode optical fibers. This optically induced acoustic resonance effectively limits the amount of optical power that can be successfully transmitted through the single mode optical fiber.

The SBS can perhaps be best explained in terms of three waves in an optical fiber. When an incident wave (also known as "pump wave") propagating along the optical fiber reaches a threshold power (which may vary), it excites an acoustic wave in the optical fiber. The optical properties of the optical fiber such as the refractive index are altered by the acoustic wave, and the fluctuation in the refractive index scatters the incident wave, thereby generating a reflected wave (also known as "Stokes wave") that propagates in the opposite direction.

Because of the scattering, power is transferred from the incident wave to the reflected wave, and molecular vibrations in the optical fiber absorb the lost energy, because of which, the reflected wave has a lower frequency than the incident wave. Hence, the scattering effect can result in attenuation, power saturation and/or backward-propagation, each of which deteriorates the DWDM system performance. Hence, the attenuation is caused by the transfer of power from the incident wave to the acoustic and reflected waves. Due to power saturation, there is a limit to the maximum amount of power that can be transmitted over the optical fiber. Also, the backward propagation wave can create noise in transmitters and saturate amplifiers.

The phenomenon of SBS has been known by optical network equipment designers for a number of years. Essentially, SBS results when a threshold power level is exceeded within a sufficiently narrow frequency band in a fiber optic light guide. The increasing operational relevance of SBS relates to the development of lasers such as, for example, single longitudinal mode lasers which readily provide an output that exceeds the SBS threshold (typically about 4 mW in, for example, a 50 kilometer fiber optic cable). Moreover, limitation of optical power to a level as low as 4 mW not only fails to utilize the output power available from state of the art lasers, but limits distance transmission through fiber optic cable by an unacceptable margin.

Various approaches to minimize the effect of SBS are also known. In general, SBS impact can be reduced in an externally modulated analog system if the optical signal's spectrum can be broadened since the energy per bandwidth is lowered. Some effective and widely used techniques for combating SBS include the use of an optical phase modulator or dithering the laser or the combination of both, in the case of external modulators.

To avoid the distortion problems related to chirp and dispersion at 1550 nm with direct modulation, low chirp external optical modulators are commonly used in analog fiber optic communication systems, such as CATV signal distribution, to amplitude modulate an optical carrier with an information or content-containing signal, such as audio, video, or data signals.

Since the present disclosure also relates to external optical modulators associated with a laser, a brief background on external optical modulators is noted here. There are two general types of external optical modulators implemented as semiconductor devices known in the prior art: Mach Zehnder modulators and electro-absorption modulators. A Mach-Zehnder modulator splits the optical beam into two arms or paths on the semiconductor device, one arm of which incorporates a phase modulator. The beams are then recombined which results in interference of the two wavefronts, thereby amplitude modulating the resulting light beam as a function of the modulated bias signal applied to the phase modulated arm. An electro-absorption modulator is implemented as a waveguide in a semiconductor device in which the absorption spectrum in the waveguide is modulated by an applied electric bias field, which changes the band gap energy in that region of the semiconductor, thereby modulating the amplitude or intensity of the light beam traversing the waveguide.

Attention is drawn to US 2011/134957 A1 describing a coherent light source having a semiconductor laser resonator and an optical amplifier which amplifies coherent light emitted by the semiconductor laser resonator in response to current injection, in which the amount of current injected into the semiconductor laser is controlled for conformity with a chirp requirement of an optical communication system. The optical amplifier, which introduces no chirp, may be controlled to match an optical power requirement of the optical communication system. A heater may be provided to introduce a low frequency chirp in order to suppress interferometric intensity noise and unwanted second-order effects such as stimulated Brillouin Scattering. The optical, amplifier may be monolithically formed with the semiconductor laser resonator, with separate electrodes provided for injecting current into the semiconductor laser resonator and the optical amplifier.

Attention is further drawn to US 2005/018732 A1 describing a method for improving the reliability of an uncooled long reach optical transmitter operating substantially at a predetermined output power. The uncooled long reach optical transmitter in this method includes a laser, an SOA and a modulator. The laser is operated to produce a reduced power laser beam, thereby improving the laser reliability. The SOA bias current is controlled so that the SOA amplifies the reduced power laser beam to substantially maintain the predetermined output power. The SOA is sufficiently long to provide this amplification, while maintaining a reduced current density within the SOA, thereby improving the SOA reliability. Small signal chirp parameters are measured for two bias voltages of the modulator. A linear function of the modulator bias voltage versus temperature is determined. The modulator bias voltage as a function of temperature is adjusted to maintain a constant dispersion penalty for data transmission.

### SUMMARY

### Features of the Invention

Briefly, and in general terms, the present disclosure provides a method of operating a semiconductor device as defined in claim 1.

Preferred embodiments are defined in the appended dependent claims.

In some embodiments, the modulator generates electrical current from the photovoltaic effect, the current being withdrawn or extracted from the modulator.

In some embodiments, the carrier density along the length of the semiconductor modulator in the direction of the optical beam is modulated, thereby optically modulating the cw optical beam entering the modulator.

In some embodiments, the gain peak wavelength of the optical signal as a function of wavelength is at least 10 nm greater than the wavelength of the cw optical beam.

In some embodiments, the semiconductor device 1s operated in the negative current region of the I-V characteristic.

In some embodiments, the gain peak wavelength associated with the modulator is between 20 and 40 nm greater than the wavelength of the light applied to the modulator.

In some embodiments, the bias is in the range of 0.6 to 1.0 volts with the coherent light beam being applied to the optical input.

In some embodiments, the bias is in the range of 0.7 to 0.9 volts with the coherent light beam being applied to the optical input.

In some embodiments, the bias is in the range of 0.85 to 1.05 volts with the coherent light beam being applied to the optical input.

In some embodiments, the bias is 0.8 volts with the coherent light beam being applied to the optical input.

In some embodiments, the bias is 0.95 volts with the coherent light beam being applied to the optical input.

In some embodiments, the modulator junction voltage with no net current injection of extraction is in the range of 0.7 to 0.9 volts with the coherent light beam being applied to the optical input.

In some embodiments, the modulator junction voltage with no net current injection of extraction is 0.8 volts with the coherent light beam being applied to the optical input.

In some embodiments, the modulator is optically pumped by the light beam from the laser to a level of 0.8 volts.

In another aspect, in operation the modulator generates electrical current from the photovoltaic effect, which is withdrawn from the modulator.

In another aspect, the carrier density along the length of the semiconductor modulator in the direction of the optical beam is modulated, thereby optically modulating the cw optical beam entering the modulator.

In another aspect, the modulator comprises an InP semiconductor waveguide structure.

In another aspect, the laser comprises an InP semiconductor gain structure having a mirrored first end region and a second end region disposed adjacent to the modulator.

In another aspect, the laser includes a first electrode disposed over the InP semiconductor gain structure.

In another aspect, the present disclosure is also related generally to the phenomenon of Stimulated Brillouin Scattering (hereinafter SBS) in the light guide of an optical communication system and more particularly to a method and associated apparatus for adjusting and optimizing the SBS performance of such an optical communication system by using, in some embodiments, a 2.4 GHz signal applied to an electrode over the laser gain region.

In some embodiments, the laser further comprises a signal source that applies a 2.4 GHz signal to the first electrode of the laser for SBS suppression.

In another aspect, the modulator includes second electrode disposed over the InP semiconductor waveguide structure.

In the present invention, the laser and the modulator are integrated on a single semiconductor substrate. In a preferred embodiment, the separation channel is a vertical gap extending approximately one micron into the substrate electrically separates the laser and the modulator. In the embodiment of the present invention, the laser and modulator are optically connected by a common optical waveguide.

Additional objects, advantages, and novel features of the present invention will become apparent to those skilled in the art form this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments within the scope of the claims.

### BRIEF DESCRIPTION OF THE DRAWINGS

These and other features and advantages of this invention will be better understood and more fully appreciated by reference to the following detailed description when considered in conjunction with the accompanying drawings, wherein:
FIG. 1 is an example of an externally modulated optical transmission system known in the prior art;
FIG. 2 is a first embodiment of an external modulator coupled to a laser according to the present disclosure;
FIG. 3 is a second embodiment of an external modulator coupled to a laser according to the present disclosure;
FIG. 4 is a graph of the current versus voltage operating characteristics of an electrooptical modulator for various input powers in the prior art and according to the present disclosure;
FIG. 5 is a graph depicting the modulator output power versus the modulator input power at various current operation levels according to the present disclosure;
FIG. 6 is a graph depicting the modulator output power versus the modulator input power at various operation levels according to a Mach Zehnder or EA modulator known in the prior art;
FIG. 7 is a graph depicting the modal gain versus wavelength showing the gain peak wavelength for a given composition of the modulator waveguide;
FIG. 8 is a graph depicting the modal gain versus wavelength showing the gain peak wavelength and a range of potential operating wavelengths for the design of a modulator waveguide;
FIG. 9 is a graph depicting the modal gain versus wavelength showing the gain peak wavelength and a selected operating wavelength for a given composition of the modulator waveguide;
FIG. 10 is a graph depicting the modal gain versus wavelength showing the gain peak wavelength from an electroluminescence measurement of a specimen test modulator at various modulator current values;
FIG. 11 is a graph depicting the gam peak wavelength versus current from an electroluminescence measurement of a specimen test modulator at various modulator current values; and
FIG. 12 is a cross-sectional of another embodiment of an external modulation coupled to a laser according to the present disclosure.

Additional objects, advantages, and novel features of the present invention will become apparent to those skilled in the art from this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments within the scope of the claims.

### DETAILED DESCRIPTION OF EMBODIMENTS

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

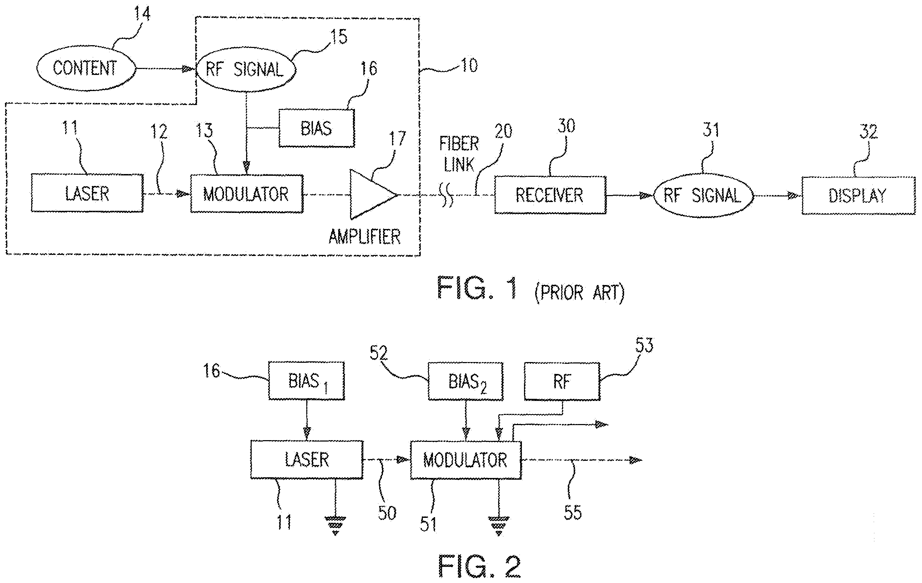

FIG. 1 is block diagram of a prior art optical transmission system in which information or "content" such as audio, video, data files, data bases, or other data is transmitted by an optical transmitter over an optical fiber link to a remote receiver, where the information content is reproduced, displayed, performed, executed or is otherwise utilized. The optical transmitter may be such as represented in U.S. Pat. No. 5,699,179 utilizing an external modulator. The transmitter, shown generally at 10, transmits an optical signal to a remote receiver 30 over an optical fiber path 20. The transmitter 10 includes a semiconductor laser 11, which produces a continuous wave (CW) output. Typical examples of such lasers are distributed feedback (DFB) lasers or Fabry-Perot lasers that produce an output optical beam at a wavelength of 1,550 nm. The un-modulated optical signal from the laser is coupled to a modulator 13 by optical fiber 12. The modulator 13 may be a single modulator such as a Mach-Zehnder modulator, a cascaded MZ modulator or more than one modulator such as in a feed-forward linearizer.

The information or content-containing signal 14, such as audio, video, or data, is initially converted into a broadband RF signal in a suitable channel or frequency band for transmission, such as an amplitude modulated vestigial sideband (AM-SDB) cable television (CATV) or video signal, or a digital signal such as a quadrature amplitude modulated (QAM) symbols which represents the data in digital format. The broadband RF signal 15 is applied to the modulator 13 via a terminal or electrode on its surface. An electrical bias 16 is also applied to the modulator 13.

The modulated optical signal which carries the video data may, in some embodiments, be coupled to an amplifier 17, which in turn is coupled to a fiber link 20. The amplifier 17 is typically an erbium doped fiber amplifier (EDFA). The amplified optical signal is transmitted over the fiber optical transmission link 20 to the receiver 30. The optical fiber transmission link 20 may be a long-distance link extending up to 100 km. In this case, line amplifiers such as EDFA 17 may be provided at spaced intervals along the line in order to boost the signal to desired levels. At the receiver 30, an amplifier (not shown) may also be provided to boost the incoming optical signal. The boosted signal is then applied to a photodetector and demodulated at the receiver 30 to an RF electrical signal 31, which is applied to a terminal or display 32 where the original audio, video or data signal is reproduced at the remote location.

FIG. 2 is a first embodiment of an optical transmitter including an external modulator coupled to a laser according to an example not falling under the scope of the present invention. There is depicted a semiconductor laser 11, which produces a continuous wave (CW) output. The laser 11 is operated at an electrical bias which is denoted as Bias (1). The un-modulated optical beam from the laser is coupled to an external modulator 51 by optical fiber 50, or by free space propagation. The modulator 51 is configured as a waveguide with electrodes coupled thereto, and operated at an electrical bias which is denoted as Bias (2), which is less than Bias (1). In some embodiments, Bias (2) may be 0.8 volts, and Bias (1) may be 1.2 volts. In some embodiments, Bias (2) may be plus or minus 0.1 volts from the value of the voltage that would have occurred if the modulator is pumped by the source laser, and no current is injected or extracted from the electrode coupled to the modulator. In some embodiments, Bias (2) may be in the range of 0.7 to 0.9 volts. In some embodiments, Bias (2) may be in the range of 0.6 to 1.0 volts.

The information-containing RF signal 53 is also applied to the electrode of the modulator 51, so that during modulation the electrical bias applied to the modulator remains less than Bias (1). The electrical bias applied to the modulator 51 determines the amount of the cw light beam from the laser 11 that is absorbed by the modulator 51. In this way, the cw light beam entering the modulator is modified or modulated by the RF signal 53. An optical output is provided for transferring the modulated optical beam to an output fiber 55.

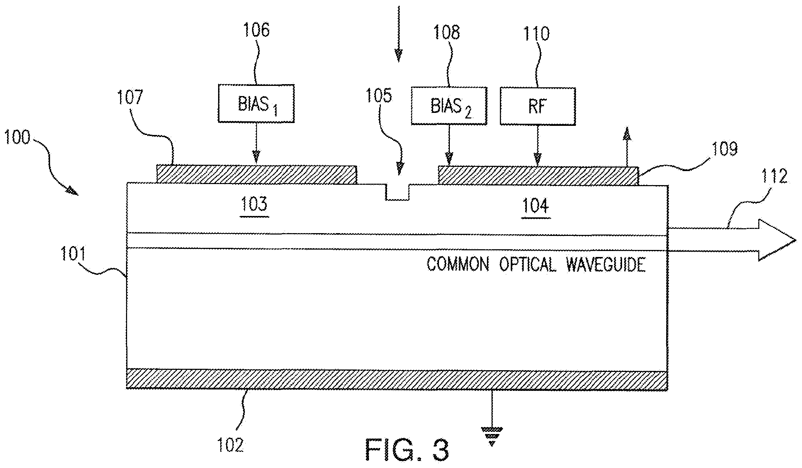

FIG. 3 is a second embodiment of an external modulator coupled to an example not falling under the scope of the present invention. The design and operation of the device of FIG. 3 is similar to that of FIG. 2, except that the laser and the modulator are implemented on a single integral semiconductor device. More particularly, there is depicted a semiconductor device 100 including a first semiconductor region 103 including a laser resonator 100 operable to produce a coherent light output in response to current injection; and a second semiconductor region 104 disposed adjacent to the first semiconductor region and separated therefrom by a channel 105. The second semiconductor region 104 has an optical input optically coupled thereto for receiving the coherent light output emitted from the first semiconductor region 103 and traversing the channel 105.

The first semiconductor device 103 is electrically biased by an electrode 107 on the top surface, which is connected to an external electrical bias potential 106 to inject current into the region 103. The second semiconductor device includes a waveguide layer for transferring the light beam from the optical input, an electrode 109 connected to a radio frequency signal input 110 and a bias potential 108 for creating an electric field in the waveguide and optically modulating the light beam as the beam traverses the waveguide. The second semiconductor device further includes an optical output 112 connected to the waveguide for transferring the modulated optical signal to an external fiber or other optical component. The bias voltage applied to the electrode 109 is appropriately selected so that the coherent light beam in the waveguide is optically modulated by the applied RF signal by modifying or modulating the absorption characteristic in the semiconductor device while the current generated in the waveguide as a result of photoabsorption of the continuous wave coherent light beam is extracted from the semiconductor device. The RF and DC currents generated are sunk by the RF source and DC bias respectively.

In some embodiments, the laser and the modulator comprise a single chip InP semiconductor device. The laser may comprise an InP semiconductor gain structure region 103 having a mirrored first end region and a second end region disposed adjacent to the modulator. The first electrode 107 is disposed over the InP semiconductor gain structure 103, and the second electrode 109 is disposed over the InP semiconductor waveguide structure 104, and a ground electrode 102 is provided extending over the bottom surface of the entire semiconductor structure.

In the embodiment in which the laser and the modulator are integrated on a single semiconductor substrate, a vertical gap extending about 1 micron into the substrate electrically separates the laser and the modulator, or the first and second semiconductor regions 103 and 104.

In other examples, not falling under the scope of the present invention, the laser and the modulator are implemented on two adjacent discrete semiconductor devices, such as depicted in FIG. 2. In some embodiments, an air gap having a width of less than 1 micron may separate the laser and the modulator devices.

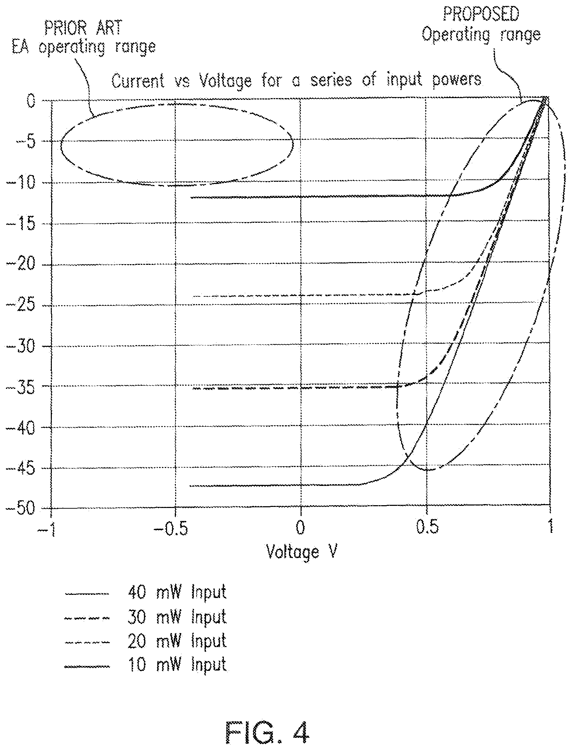

The first semiconductor device 103 is electrically biased by an electrode 107 on the top surface, which is connected to an external electrical bias potential 106. The second semiconductor device 104 is electrically biased at a lower second bias potential than the first semiconductor device 103. The specific biasing of the second semiconductor device 104 and the operating current versus voltage characteristics of the device will be described in greater detail with reference to FIG. 4.

FIG. 4 is a graph of the current versus voltage operating characteristics of an electrooptical modulator for various input powers (i.e., 10 mW, 20 mW, 30 mW, and 40 mW) of the cw optical beam in the prior art and according to the present disclosure. In the prior art, in an electro-absorption modulator, the waveguide is biased to operate in a negative voltage, negative current region as shown by the dashed line region marked "PRIOR ART EA OPERATING RANGE". In the modulator according to the present disclosure, the waveguide is biased to operate in a positive voltage, higher negative current region as shown by the dashed line region marked "PROPOSED OPERATING RANGE".

In the absence of any applied bias signal, a small amount of the cw optical beam is absorbed in the modulator and this causes a steady-state carrier density to build up in the modulator. These carriers recombine with a typical lifetime of about one nanosecond. An equilibrium level is reached when the number of carriers generated by optical absorption balances the number lost through recombination. In an embodiment, the absorption is high when the carrier level is low and the absorption is low when the carrier density is high. When the bias signal is applied, carriers are extracted from the modulator. This lowers the carrier density, and therefore increases absorption of the modulator. In particular, if a current of -10 mA is extracted from the modulator, then the absorption is increased by an amount required to produce that current of -10 mA. Similarly, if a current of -20 mA is extracted from the modulator, then the absorption is increased by an amount required to produce that current of -20 mA. Another way of describing the operation is that carriers in the semiconductor waveguide generated by the cw optical beam are excited into a conduction band and are extracted from the semiconductor region by an applied electrical bias field.

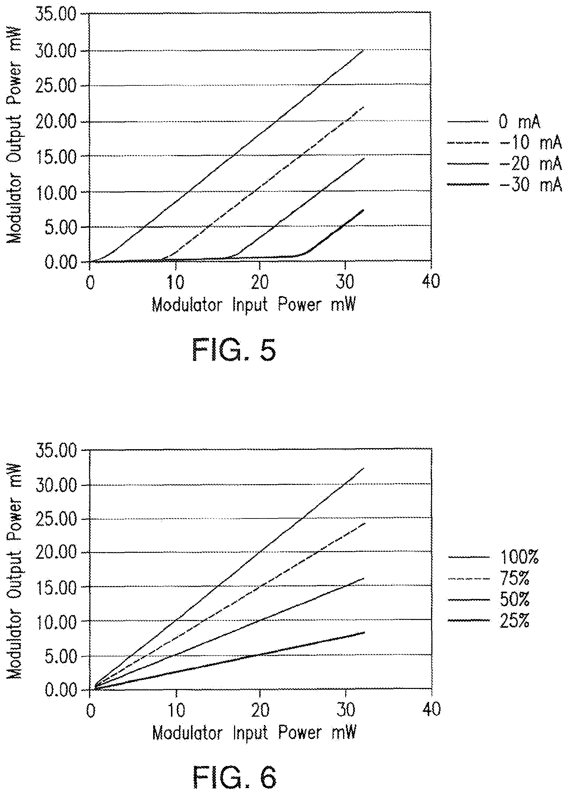

FIG. 5 shows a graph of the output power vs input power for the modulator according to the present disclosure with the parameter being the current extracted from the modulator. Since the proposed modulator has a low RF impedance, it is possible to modulate it in a manner that is close to a current source modulation (at least down to the point that the output power is close to 0). As can be seen from the FIG. 5, this really modulates the saturation power of the device. When operated at a fixed input power of say 30 mW, the net effect is a modulation of the optical output power. The operation is analogous to an optical power subtraction device in which an amount of light corresponding to the extracted current is absorbed from the input cw optical beam. In effect, after the amount of light corresponding to the extracted current is absorbed, that absorption mechanism is saturated.

The operation of the modulator of FIG. 5 should be contrasted with a traditional modulator where the optical transmission factor is modulated. FIG. 6 shows what happens with a MZ or EA type modulator. The parameter in this FIG. 6 is the transmission through the modulator. For a fixed input power of 30 mW, a modulated output similar to the output of the proposed modulator is produced. However, variation of the output optical power with input optical power with a fixed bias signal is substantially linear, in contrast to the saturation-type variation of the proposed modulator. This reflects the fundamentally different modulation mechanism involved in the proposed modulator.

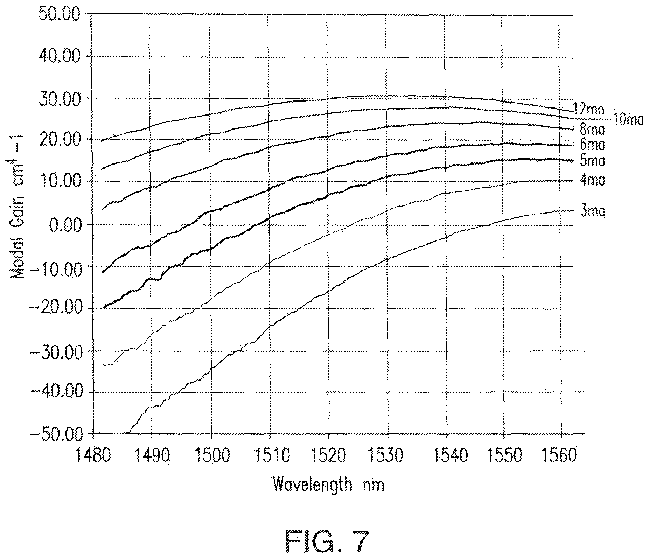

FIG. 7 is a graph depicting the modal gain versus wavelength showing the gain peak wavelength for a given composition of the modulator waveguide. It is noted that there are different maximum or peak values of the modal gain for different current values through the modulator.

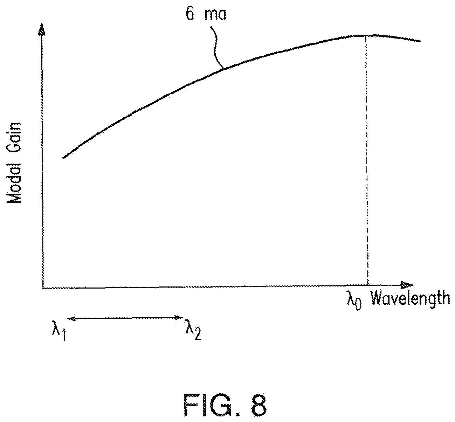

FIG. 8 is a graph depicting the modal gain versus wavelength showing the gain peak wavelength and a range of potential operating wavelengths for the design of a modulator waveguide.

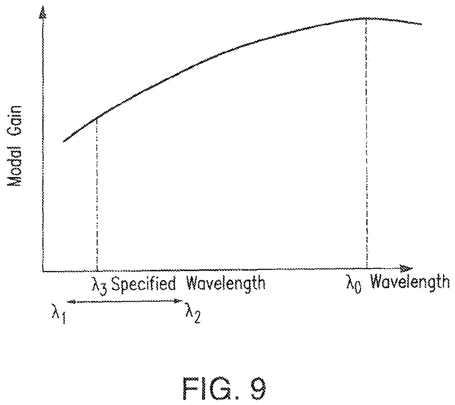

FIG. 9 is a graph depicting the modal gain versus wavelength showing the gain peak wavelength and a selected operating wavelength for a given composition of the modulator waveguide.

In the proposed device according to the present disclosure, the material in the modulator section 104 is mostly pumped by the light coming from the source laser 103 that is operating DC. In a test environment, one may evaluate the modulator under the open circuit condition where one is neither injecting nor extracting DC current from the modulator. Under this open circuit condition, the material in the modulator section 104 is pumped to give a carrier density just below the level for which the material becomes optically transparent or has no net absorption or gain. The modulator junction under this condition is at a voltage corresponding to about 0.8 volts forward bias (analogous to the open circuit voltage of a solar cell).

The modulator does not have to be used with the open circuit bias condition. One can either bias the modulator by injecting current, in which case the material will move towards optical gain or extracting current, in which case the absorption increases compared to the open circuit bias condition. The current values in the curves graphed in FIG. 7 are merely intended as nominal or representative to depict typical gain peak wavelengths at different current values, since the depicted data is derived from a prototype test structure that is only electrically pumped, unlike the proposed modulator that would be used in actual practice and which would be mostly optically pumped. Although experimentally one cannot directly measure the optical gain curves for the optically pumped case, the data is suggestive and it is believed that the corresponding curves for the optically pumped case move up and to the left for increasing current, similarly to the curves graphed in FIG. 7 for electrically pumped test structures.

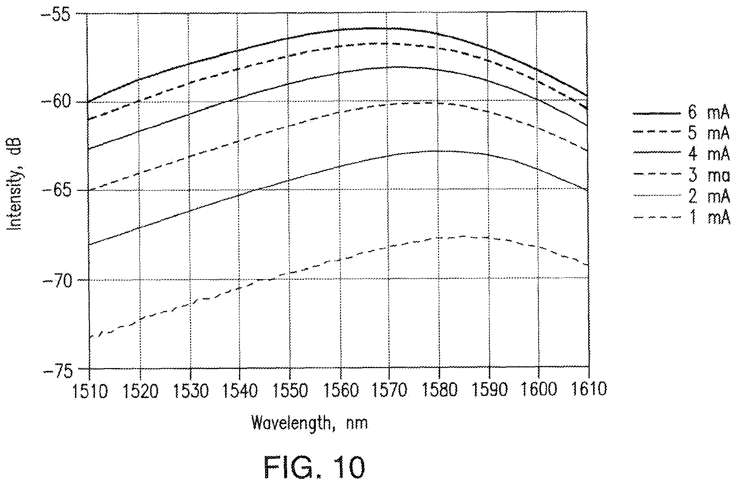

The present disclosure does not specify the signal wavelength relative to the modulator gain curve, since that may depend upon other product design specifications and the customer application environment. However, one aspect of the present disclosure is the fabrication method for the design of an optical modulator and how to specify the wavelength of the material for given operational specifications or requirements. Two methods are reasonable and are embodiments of the present disclosure. One is determining the photoluminescence (PL) peak wavelength. In this case the material is optically pumped and the spectrum of the light emitted from the material is measured by commercially available photoluminescence instruments. This measurement of the photoluminescence (PL) peak wavelength is not the same as measurement of the gain curve, but they are related. For example the material used for the gain data presented in FIG. 10 has a PL peak wavelength of 1574 nm. A second method would be to specify the peak of the gain curve under some specific pumping condition. No pumping at all is not a good experimental approach for specifying a gain peak since there isn't any gain peak, the absorption just gets steadily larger as the wavelength is reduced. Pumping the modulator until there is a peak in the gain at some specific level is another way to try to specify this, but it is believed to be less well defined than the PL peak. One embodiment of the present disclosure therefore provides making a PL measurement and using the PL wavelength so determined as a method of characterizing the material. In terms of operation, one would want to have the signal wavelength be below the PL peak, which is different from the design of the semiconductor material in an EA modulator where the signal wavelength in the EA modulator is typically much greater than the peak PL wavelength. One embodiment of the present disclosure therefore provides the selection or specification of the operating wavelength that one is at least 10 nm below the PL peak. In some embodiments, the selection or specification of the operating wavelength is one that is 30 nm below the PL peak.

FIG. 10 is a graph depicting the modal gain versus wavelength showing the gain peak wavelength from an electro luminescence (EL) measurement of a specimen test modulator at various modulator current values. In one embodiment of the present disclosure, the peak wavelength extrapolated to zero current is an appropriate and precise way to characterize the material. In this case illustrated in FIG. 10, the peak wavelength is about 1589 nm. This is not the same as the PL characterization which was 1574 nm for the same test wafer. In terms of the operating wavelengths that would use with this material, in one embodiment of the present disclosure, suitable wavelengths would be in the range of 1540 to 1550 nm. In another embodiment of the present disclosure, the operating wavelength would be at least 30 nm below the gain peak wavelength. In another embodiment of the present disclosure, the operating wavelength would be in the range of 40 to 30 nm below the gain peak wavelength.

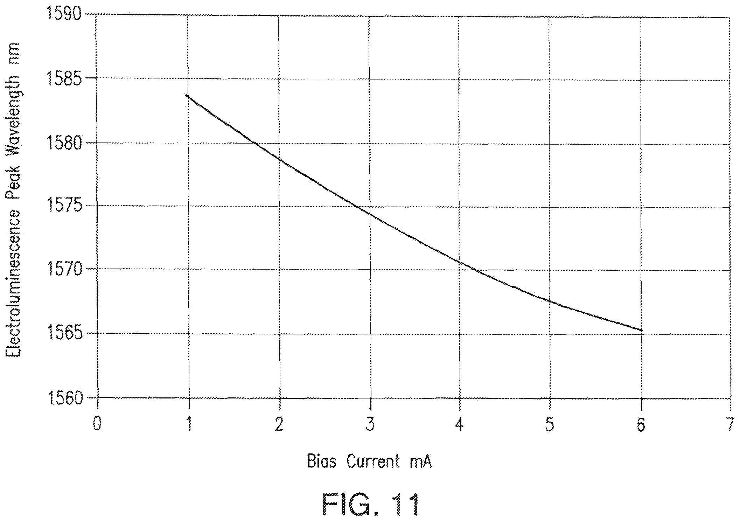

FIG. 11 is a graph depicting the gain peak wavelength versus current from an electroluminescence measurement of a specimen test modulator at various modulator current values.

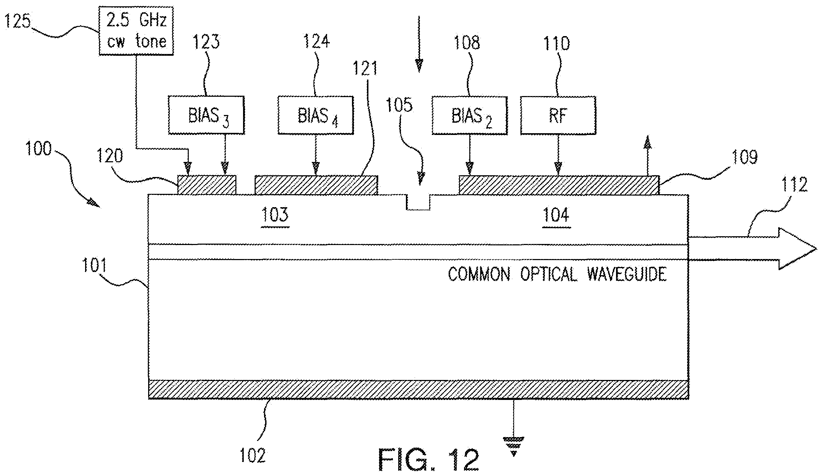

FIG. 12 is a cross-sectional view of the embodiment according to the present invention. In this embodiment, in place of a single electrode 107 shown in FIG. 3, there are two electrodes 120 and 121 which have lengths L₁ and L₂ respectively, and are spaced apart along the common optical waveguide over region 103. A first current I₁ is applied to the first electrode 120, and a second current I₂ is applied to the second electrode 121.

In the embodiment of the present invention, the ratio I₁/L₁ is greater the I₂/L₂. In some embodiments, the ratio I₁/L₁ is at least two times greater as I₂/L₂.

In some embodiments, L₂ is greater that Li, and more specifically, in some embodiments at least four times as great as L₁. In some embodiments, L₂ may be four to six times as great as L₁.

A SBS signal source 125 is provided that generates a suitable signal applied to the first electrode 120. As we noted above, the impact of SBS in an optical network can be reduced in an externally modulated system if the optical signal's spectrum can be broadened since the energy per bandwidth is lowered. Thus, in the embodiment of the present invention, the SBS signal source 125 is provided that functions for dithering the laser to broaden its spectrum. These "dither signals" are implemented to spread the output power of the associated laser over a wider range of optical wavelengths. The SBS signal source 125 is a high frequency signal that has a frequency at least twice that of the radio frequency information-containing signal source.

In some embodiments, the SBS signal source 125 is at least a 2.4 GHz signal generator. In some embodiments, the SBS signal source 125 is a 2.5 GHz signal generator.

The ratio I₁/L₁ and I₂/L₂ are suitably selected to achieve the appropriate level of SBS suppression for the optical network application.

## Claims

1. A method for operating a semiconductor device wherein:
the semiconductor device (100) comprises:
(A) a substrate;
(B) a first semiconductor region (103) disposed on the substrate and operable to produce optical gain in response to current injection, a reflective mirror (101) provided at one end of the first semiconductor region (103), and a grating formed in the first semiconductor region (103), so that the first semiconductor region (103) includes a laser resonator;
(C) a first laser electrode (120) over a first portion of the first semiconductor region (103) having a first length L₁;
(D) a second laser electrode (121) over a second portion of the first semiconductor region (103) having a second length L₂;
(E) a second semiconductor region (104) disposed on the substrate adjacent to the first semiconductor region (103) and separated therefrom by a channel (105), the second semiconductor region (104) having the same composition as the first semiconductor region (103), and including a common waveguide connecting the laser resonator to the second semiconductor region (104) for receiving optical energy emitted from the laser resonator;
(F) a third electrode (109) disposed over the second semiconductor region (104) and arranged so as to bias the second semiconductor region (104) at a bias potential (Bias₂) that is lower than bias potentials of the first and second electrodes (120, 121); and
(G) a source (110) of a radio-frequency information-containing signal, wherein the signal source is electrically coupled to the third electrode (109);
and the method comprises:
(i) applying a first electrical laser drive current I₁ to the first laser electrode (120) and applying a second electrical laser drive current I₂ to the second laser electrode (121), with I₁/L₁ greater than I₂/L₂, thereby causing the laser resonator to emit the optical energy along the common waveguide;
(ii) applying the radio-frequency information-carrying signal to the third electrode (109), so that current is generated in the second semiconductor region (104) and extracted therefrom in response to application of the radio-frequency information-carrying signal, so that the second semiconductor region (104) forms an optical modulator configured for optically modulating the emitted optical energy according to the applied radio-frequency information-carrying signal; and
(iii) applying a high-frequency signal to the first electrode (120) that oscillates at a frequency at least twice that of the radio-frequency information-carrying signal, to suppress stimulated Brillouin scattering, SBS.

2. The method of Claim 1 wherein I₁/L₁ is at least two times greater than I₂/L₂.

3. The method of Claim 1 wherein I₁/L₁ is at least five times greater than I₂/L₂.

4. The method of any one of Claims 1 through 3 wherein L₂ is at least four times longer than L₁.

5. The method of any one of Claims 1 through 3 wherein L₂ is five times longer than L_{1.}

6. The method of any one of Claims 1 through 5 wherein the semiconductor device includes an InP semiconductor waveguide structure.

7. The method of any one of Claims 1 through 6 wherein the high-frequency signal oscillates at a frequency of 2.4 GHz.

8. The method of any one of Claims 1 through 7 further comprising outputting the modulated optical beam into an optical output fiber (55).

9. The method of any one of Claims 1 through 8 wherein the first and second semiconductor regions (103, 104) form a laser gain region and a modulator region, respectively, and wherein both regions include a multi-quantum-well structure.

10. The method of claim 9, wherein the operating wavelength of the modulator region is between 1540 nm and 1550 nm

## Patentansprüche

1. Ein Verfahren zum Betreiben einer Halbleitereinrichtung, wobei:
die Halbleitereinrichtung (100) Folgendes aufweist:
(A) ein Substrat;
(B) eine erste Halbleiterregion (103), die auf dem Substrat angeordnet ist und betreibbar ist zum Erzeugen einer optischen Verstärkung ansprechend auf eine Stromeinspeisung, einen reflektierenden Spiegel (101), der an einem Ende der ersten Halbleiterregion (103) vorgesehen ist, und ein Gitter, das in der ersten Halbleiterregion (103) ausgebildet ist, so dass die erste Halbleiterregion (103) einen Laserresonator beinhaltet;
(C) eine erste Laserelektrode (120) über einem ersten Abschnitt der ersten Halbleiterregion (103) mit einer ersten Länge L₁;
(D) eine zweite Laserelektrode (121) über einem zweiten Abschnitt der ersten Halbleiterregion (103) mit einer zweiten Länge L₂;
(E) eine zweite Halbleiterregion (104), die auf dem Substrat benachbart bzw. angrenzend zu der ersten Halbleiterregion (103) angeordnet ist und davon durch einen Kanal (105) separiert bzw. getrennt ist, wobei die zweite Halbleiterregion (104) die gleiche Zusammensetzung hat wie die erste Halbleiterregion (103), und einen gemeinsamen Wellenleiter beinhaltet, der den Laserresonator mit der zweiten Halbleiterregion (104) zum Empfangen einer optischen Energie verbindet, die von dem Laserresonator emittiert wird;
(F) eine dritte Elektrode (109), die über der zweiten Halbleiterregion (104) angeordnet ist und ausgelegt ist zum Vorspannen der zweiten Halbleiterregion (104) auf ein Vorspannungspotenzial (Bias₂), das niedriger ist als die Vorspannungspotenziale der ersten und zweiten Elektroden (120, 121); und
(G) eine Quelle (110) eines Information enthaltenden Funkfrequenzsignals, wobei die Signalquelle elektrisch an die dritte Elektrode (109) gekoppelt ist;
und das Verfahren Folgendes aufweist:
(i) Anlegen eines ersten elektrischen Lasertreibstroms I₁ an die erste Laserelektrode (120) und Anlegen eines zweiten elektrischen Lasertreibstroms **I₂** an die zweite Laserelektrode (121), wobei I₁/L₁ größer als I₂/L₂ ist, wodurch der Laserresonator veranlasst wird, die optische Energie entlang des gemeinsamen Wellenleiters zu emittieren;
(ii) Anlegen des Information tragenden Funkfrequenzsignals an die dritte Elektrode (109), so dass Strom in der zweiten Halbleiterregion (104) generiert wird und daraus ansprechend auf eine Anwendung des Information tragenden Funkfrequenzsignals extrahiert wird, so dass die zweite Halbleiterregion (104) einen optischen Modulator bildet, der konfiguriert ist zum optischen Modulieren der emittierten optischen Energie gemäß dem angelegten Information tragenden Funkfrequenzsignal; und
(iii) Anlegen eines Hochfrequenzsignals an die erste Elektrode (120), die mit einer Frequenz oszilliert, die wenigstens das Doppelte ist von der des informationstragenden Funkfrequenzsignals, um stimulierte Brillouin-Streuung bzw. SBS (SBS = stimulated Brillouin scattering) zu vermeiden.

2. Verfahren nach Anspruch 1, wobei I₁/L₁ wenigstens zweimal größer als I₂/L₂ ist.

3. Verfahren nach Anspruch 1, wobei I₁/L₁ wenigstens fünfmal größer als I₂/L₂ ist.

4. Verfahren nach einem der Ansprüche 1 bis 3, wobei L₂ wenigstens viermal länger als L₁ ist.

5. Verfahren nach einem der Ansprüche 1 bis 3, wobei L₂ fünfmal länger als L₁ ist.

6. Verfahren nach einem der Ansprüche 1 bis 5, wobei die Halbleitereinrichtung eine InP-Halbleiterwellenleiterstruktur beinhaltet.

7. Verfahren nach einem der Ansprüche 1 bis 6, wobei das Hochfrequenzsignal mit einer Frequenz von 2,4 GHz oszilliert.

8. Verfahren nach einem der Ansprüche 1 bis 7, das weiter Ausgeben des modulierten optischen Strahls in eine optische Ausgabefaser (55) aufweist.

9. Verfahren nach einem der Ansprüche 1 bis 8, wobei die erste und zweite Halbleiterregion (103, 104) eine Laserverstärkungsregion bzw. eine Modulatorregion bilden, und wobei beide Regionen eine Multi-Quantum-Well-bzw. - Wannenstruktur beinhalten.

10. Verfahren nach Anspruch 9, wobei die Betriebswellenlänge der Modulatorregion zwischen 1540 nm und 1550 nm liegt.

## Revendications

1. Procédé destiné à faire fonctionner un dispositif semiconducteur dans lequel :
le dispositif semiconducteur (100) comprend :
(A) un substrat ;
(B) une première région semiconductrice (103) disposée sur le substrat et utilisable pour produire un gain optique en réponse à une injection de courant, un miroir réfléchissant (101) étant prévu à une extrémité de la première région semiconductrice (103), et un réseau de diffraction étant formé dans la première région semiconductrice (103), de sorte que la première région semiconductrice (103) comporte un résonateur laser ;
(C) une première électrode laser (120) sur une première partie de la région semiconductrice (103) ayant une première longueur L₁ ;
(D) une deuxième électrode laser (121) sur une deuxième portion de la région semiconductrice (103) ayant une deuxième longueur L₂ ;
(E) une deuxième région semiconductrice (104) disposée sur le substrat adjacente à la première région semiconductrice (103) et séparée de celle-ci par un canal (105), la deuxième région semiconductrice (104) ayant la même composition que la première région semiconductrice (103), et comportant un guide d'onde commun connectant le résonateur laser à la deuxième région semiconductrice (104) pour recevoir une énergie optique émise par le résonateur laser ;
(F) une troisième électrode (109) disposée sur la deuxième région semiconductrice (104) et agencée de sorte à polariser la deuxième région semiconductrice (104) à un potentiel de polarisation (Bias₂) qui est inférieur à des potentiels de polarisation des première et deuxième électrodes (120, 121) ; et
(G) une source (110) d'un signal contenant des informations radiofréquence, dans lequel la source de signal est électriquement reliée à la troisième électrode (109) ;
et le procédé comprend :
(i) l'application d'un premier courant électrique d'excitation laser I₁ à la première électrode laser (120) et l'application d'un deuxième courant électrique d'excitation laser I₂ à la deuxième électrode laser (121), où I₁/L₁ est supérieur à I₂/L₂, amenant ainsi le résonateur laser à émettre l'énergie électrique le long du guide d'onde commun ;
(ii) l'application du signal contenant les informations radiofréquence à la troisième électrode (109), de sorte que le courant est généré dans la deuxième région semiconductrice (104) et extrait de celle-ci en réponse à l'application du signal contenant les informations radiofréquence de sorte que la deuxième région semiconductrice (104) constitue un modulateur optique configuré pour moduler optiquement l'énergie optique émise conformément au signal contenant les informations radiofréquence ; et
(iii) l'application d'un signal haute fréquence à la première électrode (120) qui oscille à une fréquence au moins double de celle du signal contenant les informations radiofréquence pour supprimer les dispersions de Brillouin stimulées, SBS.

2. Procédé selon la revendication 1, dans lequel I₁/L₁ est au moins deux fois supérieur à I₂/L₂.

3. Procédé selon la revendication 1, dans lequel I₁/L₁ est au moins cinq fois supérieur à I₂/L₂.

4. Procédé selon l'une quelconque des revendications 1 à 3, dans lequel L₂ est quatre fois plus longue que L₁.

5. Procédé selon l'une quelconque des revendications 1 à 3, dans lequel L₂ est cinq fois plus longue que L₁.

6. Procédé selon l'une quelconque des revendications 1 à 5, dans lequel le dispositif semiconducteur comporte une structure de guide d'ondes semiconducteur à InP.

7. Procédé selon l'une quelconque des revendications 1 à 6, dans lequel le signal haute-fréquence oscille à une fréquence de 2,4 GHz.

8. Procédé selon l'une quelconque des revendications 1 à 7, comprenant en outre la fourniture en sortie du faisceau optique modulé dans une fibre optique de sortie (55).

9. Procédé selon l'une quelconque des revendications 1 à 8, dans lequel les première et deuxième régions semiconductrices (103, 104) forment une région de gain laser et une région de modulateur, respectivement, et dans lequel les deux régions comportent une structure à plusieurs puits quantiques.

10. Procédé selon la revendication 9, dans lequel la longueur d'onde de fonctionnement de la région de modulateur est comprise entre 1540 nm et 1550 nm.
